Europäisches Patentamt

European Patent Office

Office européen des brevets

(19)

(11) Publication number: **0 178 804**
A2

(12) # EUROPEAN PATENT APPLICATION

(21) Application number: 85306697.5

(22) Date of filing: 20.09.85

(51) Int. Cl.⁴: **H 02 J 13/00**
H 04 B 3/54, G 01 R 21/00

(30) Priority: 13.10.84 GB 8425919

(43) Date of publication of application:
23.04.86 Bulletin 86/17

(84) Designated Contracting States:
AT BE CH DE FR IT LI LU NL SE

(71) Applicant: STANDARD TELEPHONES AND CABLES
PUBLIC LIMITED COMPANY
190 Strand
London, WC2R 1DU(GB)

(72) Inventor: Scarr, Robert Walter Alister
63 Lower Street
Stansted Essex. CM24 8LR(GB)

(72) Inventor: Ettinger, Joseph Emil
7 The Woodlands
London SE13 6TZ(GB)

(74) Representative: Capsey, Sydney Ross et al,
Standard Telephones and Cables Patent Department
Edinburgh Way
Harlow Essex CM20 2SH(GB)

(54) Remote meter reading.

(57) The readings of electricity meters are conveyed to a substation from a customer's premises over the mains wiring. The data is transmitted on the circuit between the mains neutral wire and ground, the transceivers at the two ends being transformer-coupled to the neutral image.

Transmission uses frequency-hopping spread-spectrum techniques, with each customer allocated a couple of blocks of frequencies, one for bit 0 and one for bit 1. At each data transmission samples are made for voltage (once) and current (three times), with the samples digitized, and then modulated on to the spread spectrum frequency hopping system.

EP 0 178 804 A2

## REMOTE METER READING

### Field of the Invention

This invention relates to the remote reading of meters, and also to the transmission of other data, via the electrical supply mains.

### Background and Prior Art

The electrical mains is subject to much noise interference, so that the method of digital transmission used has to be substantially noise immune. Various methods have been proposed for noise-immune data transmission, not necessarily intended for use in the present context, and some of these will be briefly mentioned.

Thus British Patent No. 958763 (Motorola) describes a system in which the presence or absence of a pulse constitutes the information to be transmitted. Each such pulse is allotted a preset number of time slots and is sent as a set of short pulses of different frequencies in selected ones of the time slots. Each receiver is allotted its own combination of frequencies, and can only respond to signals of that combination. Hence two or more calls can be in existence at the same time over a single channel.

Then British Patent Application No. 2098030A (GEC) describes a system in which high bit rate digital data is transmitted via a power line with a high harmonic noise content. This system uses an FM chirp signal whose frequency is a preset centre frequency at the start, midpoint and end of each bit-time interval, and varies linearly between those points. The frequency varies to a maximum and a minimum frequency once per bit interval, the maximum and minimum, and the minimum and maximum frequencies being at one quarter and at three quarters of the bit interval for 0 and 1 respectively.

The signal is decoded by frequency demodulating the signal, integrating the demodulated signal and comparing the integrated signal with a reference level. The integrated signal is full-wave rectified and passed to a threshold detector to recover the bit clock.

In British Patent Application No. 2092415A (Secretary of State for Defence) there is described a slow-speed HF communications modem which uses frequency and time diversity to overcome transmission problems due to noise, multi-path, etc. A digitally encoded signal is sent consecutively on five complementary two-tone channels distributed within the HF field. An unique Start of Message (SOM) signal is generated to precede a message, and an end of message (EOM) signal follows the message. The SOM signal is detected to produce an accurate timing pulse, which initiates the clock in the receiver modem to sample each channel tone at times appropriate to the reception of message signals. The noise in each channel tone is also sampled before and after a signal data bit, and the measured pre- and post-data bits are combined to assign a weighting factor to the associated message bits. By the provision of these SOM and EOM signals the modem can operate unattended.

Thus it will be seen that broad band, and also "multi-path" transmission techniques are known where difficult, e.g. noisy, transmission media have to be used.

According to the present invention there is provided a data transmission system for use, for instance, for transmitting data relevant to meter readings, via the electrical supply wiring, in which said data is transmitted using frequency hopping spread spectrum techniques with each data message modulated in a manner appropriate to the source of the data to be transmitted, each said data message to be sent being modulated on to a quasi-random digital address code or codes appropriate to the source of the data to be transmitted, wherein at a terminal at which the data messages are to be received all incoming messages are offered for correlation to the address codes for data sources from which messages can be received at that terminal, and wherein each message thus correlated is routed to apparatus appropriate to the source thereof, e.g. to metering equipment appropriate to the message's source where the data message relates to meter readings.

The invention will be described in its application to the transmission of electricity supply meter readings over the mains wiring to an electricity supply sub-station where the meter readings are assembled for transmission to a central charging centre. However, other types of data can also be conveyed in the same way, e.g. gas meter readings.

In the case of electricity meter readings the information to be sent includes kilowatt-hours (KwH), elapsed kilowatt-hours, cumulative cost since last reading, tariff, amount pre-paid, and customer identity. Power measurement in the arrangement to be described is based on sampling the AC in the mains at a relatively high frequency compared with the mains frequency. It can be shown mathematically that a sampling frequency nine times the mains frequency ensures good accuracy. Preferably both voltage and current amplitudes are sampled. To avoid errors due to quantisation repeatedly producing an error in the same direction when sampling is harmonic, harmonic sampling is used with pseudo-random phase jitter. This reduces the systematic quantisation error and allows accurate recording of the energy consumed under pulsed current operation.

In the design of the system it has been assumed that accurate current measurement will not be needed for currents more than 20% above the expected current maximum.

A consequence of quantisation is that currents below the minimum step in the quantisation are missed, and that currents of the same order as the minimum step may be inaccurately recorded. However, linear quantisation is the preferred method as its accuracy is constant, it is simple "computation-wise", and "off the shelf" analogue-to-digital converters are available. The smallest quantisation step is 0.05Amp, and fourteen bits are used to convey binary information. At each sampling interval, one voltage and up to three current measurements are needed, one A-D (Analog-Digital) converter being used, being switched sequentially between measurement points. An A-D converter with 100 microseconds conversion time, which allows 50 samples per mains cycle, is fully satisfactory.

Mains wiring is subject to a great deal of noise interference, mainly of an oscillatory nature, and such interference may be compatible in amplitude with the data signals as received. Spread spectrum techniques minimise the adverse effects of interference generally and frequency hopping is used.

As will be seen below, signalling is effected between earth and the neutral mains wire since the interference is then at a lower level in relation to the signal than otherwise. Two alternative methods may be used, in one of which the system is earthed at the sub-station but not at the customer's premises, while in the other the system is earthed both at the sub-station and the customer's premises. The signal is coupled by transformers of which the secondary is a single turn neutral-earth loop, and the primary of the transformer is tuned to the signal carrier frequency at which it is high impedence. However, it is a low impedence at 50 Hz. The carrier frequency is in the band 40-90 KHz, and is a multiple of the code frequency used.

With the use of frequency hopping, a block of frequencies, nine in number in one case, is used with each bit for one customer.  Such a block of frequencies has a defined first frequency, and the order in which the frequencies occur in the block of frequencies for a customer is reversed to distinguish between 0 and 1. Code acquisition means that the receiver looks for the correct first frequency, and then one or other of the appropriate "next" frequencies in the group.

Brief Description of the Drawings

Fig. 1 is a block diagram of a customer's electricity meter with its transmission circuitry.

Figs. 2 and 3 are alternative ways to connect the transmitting and receiving equipments to the mains wiring.

Fig. 4 is a block schematic of a transceiver as used at a customer's premises.

Customer's Meter and Associated Transmission Circuitry

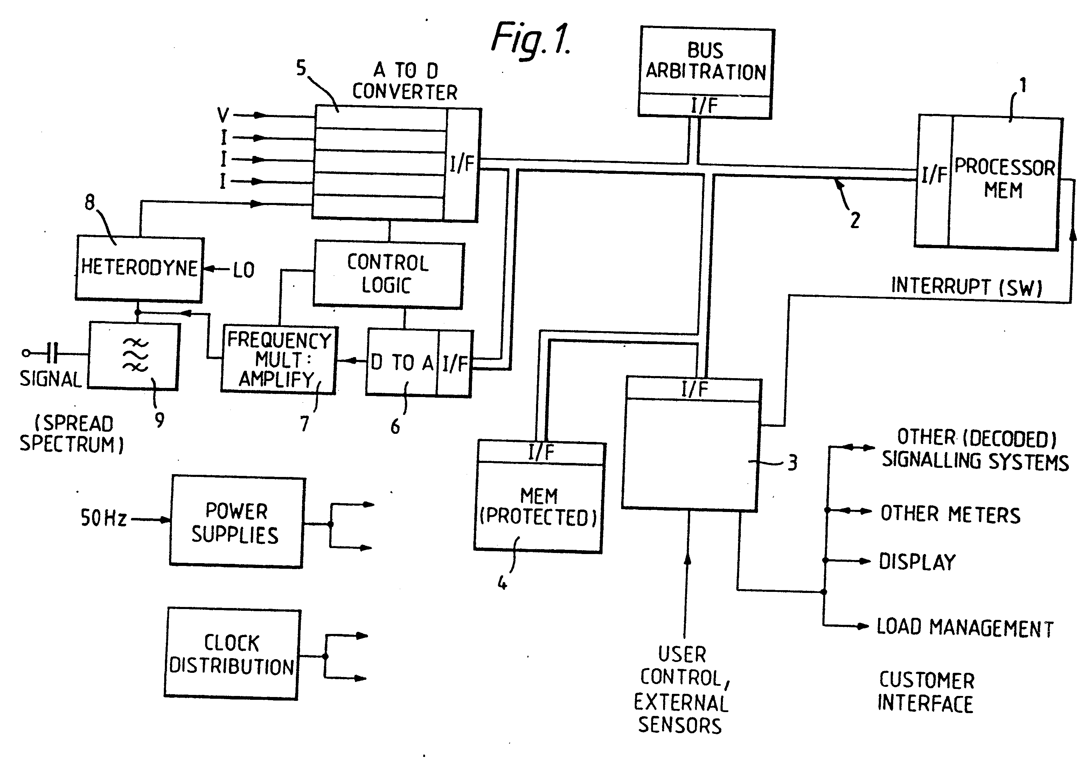

In Fig. 1, it will be seen that the arrangement is controlled by a microprocessor 1, which can be of the type described and claimed in our British Application No. 2138182A, to which correspond US Application Serial No. 595728 (A.J. McWilliam), filed April 2nd 1984. Intercommunication between the various functional blocks takes place via the processor's data bus 2.  The circuitry provides for user control using another microprocessor 3, with which is associated, inter alia, display arrangements for displaying meter information to the customer.  There is also provision for him to send data messages to the sub-station.  Information to be displayed, some of which is semi-permanent, is held in a protected memory 4 which, like the processors and other units is coupled to the data bus via an interface I/F. This information to be sent includes the current and elapsed KwH as indicated above, and can include other information entered via user control, etc.  As already indicated, the transmission to the substation uses frequency hopping, spread spectrum signalling.

The voltage and current samples taken for each sampling interval are, in the arrangement shown in Fig. 1, four in number, and these are applied to an analogue-digital converter block 5, which may in fact be a single converter switched successively between the four sampling inputs. Alternatively, it is possible to use four dedicated converters working on a delta modulation principle. The digital outputs thus produced are applied to the bus 2 from which they go to the processor block 1 for calculation of energy consumption. The results of these calculations are stored in the protected memory block 4 and are available for display via processor block 3.

For signal transmission the output produced by the processor 1 passes to a digital to analogue converter 6, which converts each sample into waveforms at one or others of a set of frequencies dependent on the identity of the customer. As indicated above, each data bit is sent as one of two sets of frequencies, and the output from the converter 6 is applied to a frequency multiplier amplifier block 7 for transmission via the band pass filter 9 over the mains. Signals received from the mains are filtered by the band pass filter 9 and changed to an intermediate frequency, for example in the range 5-15kHz, by the heterodyne unit 8 and passed to the analogue to digital converter 5.

When signal reception is to take place, the analog-to digital converter outputs are interleaved signal and energy measurements, but only energy measurements are made when signal transmission is in progress. The signal samples must be readily distinguishable from the 50 Hz voltage and current samples, and since all samples use less than 16 bits, one bit of the word is set to make this distinction. This is conveniently the most significant bit. The signal and measurement samples are multiplexed in fixed format so that any loss of samples can be detected.

The processor used in the block 3, which is one specially designed for use in association with a key set input and liquid crystal displays, is slower in operation than the processor 4, so transfer takes place an octet at a time.  In addition, acknowledgements and "handshakes" involving interrupts and transfers are used to synchronise the two processors.

Arrangements for Connection to the Mains

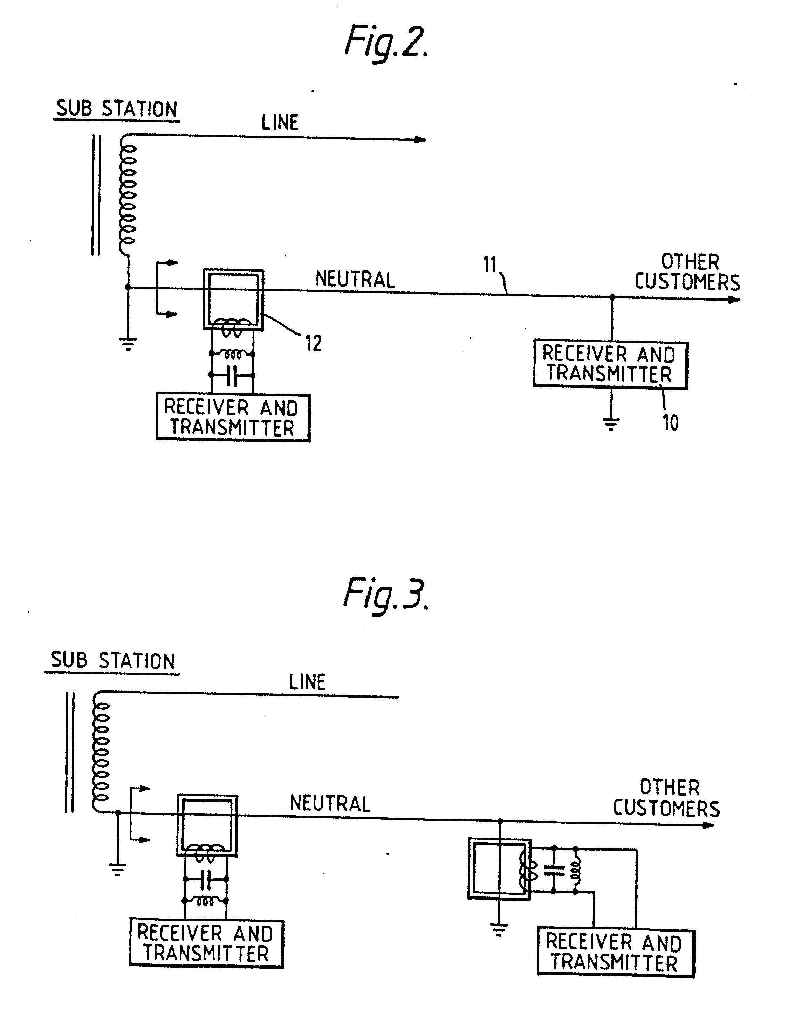

We have indicated above that the spread spectrum signalling is applied to the mains wiring between the neutral and earth.  This is shown in Fig. 2, where we see the transceiver 10 at the customer's station connected to the neutral side 11 of the mains.  Note that, as is usual in Great Britain, the mains system is not earthed at the customer's premises, although some parts of the transceiver are earthed.  At the substation the signal is coupled to and from the system by a transformer 12 with a ferrite core, one winding of this transformer being a single-turn neutral-earth loop formed by the mains neutral.  The other winding of the transformer is tuned to the signal carrier frequency which makes it present a relatively high impedence at that frequency but a low impedence at 50 Hz.  Relatively low permeability ferrite materials are used for the core to reduce the coupling at 50 Hz compared with the much higher carrier frequency.

The non-earthed customer's transceiver 10 receives a voltage signal between earth and neutral which is detected by a high impedence receiver.  The customer's transmission is also made by applying a voltage to line from a matched power source.

Fig. 3 shows the arrangement used where the system is earthed at the customer's premises as well as at the sub-station.  Here the earthed customer equipment has an arrangement which is the "mirror image" of that at the sub-station, and receives and transmits via a current transformer.  Note that in both versions, every current transformer is shunted by every other current transformer on a particular neutral feed; hence the need to tune the current transformer to the carrier frequency to reduce the shunting effect.

At the sub-station the current transformers are placed one in each of the many neutral feeders therefrom, rather than in the common earth return, which contains the sum of all the earth loop currents.

## Spread Spectrum Technique Used Herein

We have stated above that the spread spectrum method used for mains-borne signalling is frequency hopping. Such a system effects modulation by carrier frequency shifting in discrete increments in a pattern dictated by the code sequence. The transmitter jumps from frequency to frequency within a predetermined set, the order of frequency usage depending on a code sequence.

In one example there are 10 frequencies in the hopping range, with a centre frequency of 60KHz, a band spacing of 1KHz and a bandwidth of 500Hz. A convenient chip rate is 30 x 16 = 480 bits/sec. This allows an address capability of $10^{16}$. The spectrum used is 60KHz $\pm$ 5 KHz. At the receiver, a heterodyne arrangement is used with a local oscillator frequency of 70 KHz, which gives an intermediate frequency band of 10 KHz $\pm$ 5KHz. The local oscillator frequency is on the high side of the carrier, on the assumption that interference from the higher side is easier to suppress than from the lower side.

With the frequency allocations for a customer effected as indicated above, a typical customer's allocation is:

Bit zero $= f_1 \; f_5 \; f_2 \; f_6 \; f_4 \; f_9 \; f_6 \; f_3 \; f_9 \; f_7$
Bit one $\; = f_1 \; f_7 \; f_9 \; f_3 \; f_6 \; f_9 \; f_4 \; f_6 \; f_2 \; f_5$

As indicated above it is also possible for the same set of frequencies to be used for the two bit values, with the frequencies for 0 being in the reverse order to those for 1.

Code acquisition is effected by looking for the frequency $f_1$ over a time window of width $t=1/NC$, where N is the number of chips per data bit and C is the bit rate. As a message is assumed to start with several 0's, the receiver now looks for $f_5$, and if found it continues until all frequencies in its sequence are found and in the correct order. If the correct sequence is not found, it reverts to looking for $f_1$. This assumes that the receiver is looking for the sequences for a defined customer, and this is a useful method for meter reading.

Once code acquisition has occured, the receiver looks for either of the same customer's two sequences, but noting always that $f_1$ means a new code bit. Such a receiver is noise-tolerant, and can even be "programmed" to accept data with frequencies missing from a sequence.

Note that a receiver at the customer's premises would be set to respond only to that customer's two sequences, whereas at the sub-station the receiver is programmed to successively respond to messages from different receivers.

Transceiver Arrangement

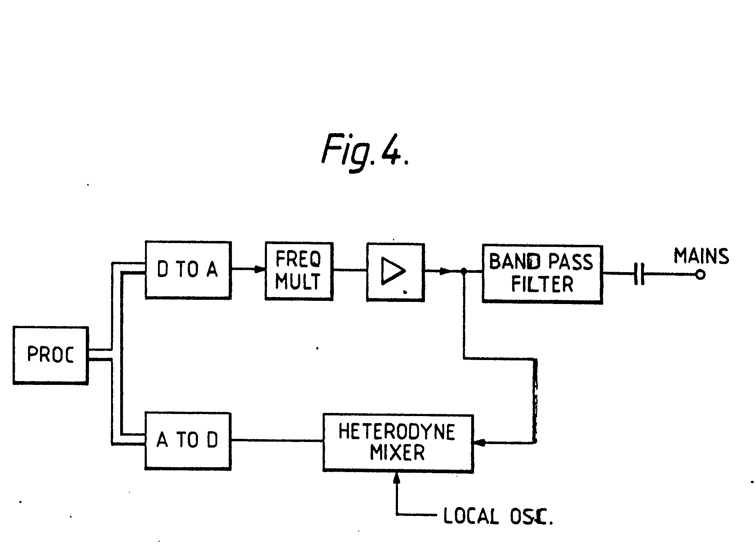

A transceiver arrangement such as used at a customer's premises is shown in block schematic form in Fig. 4. In this arrangement the processor PROC is a microprocessor of the type described and claimed in our above-quoted British Application No. 2138182A. The system functions in a half-duplex manner, and the processor acts as a frequency synthesiser in the transmit mode and as a set of filters in the receive mode. The analogue to digital converter functions in delta modulation manner as may the digital to analogue converter.

Thus the intelligence to be transmitted is applied under control of the processor PROC to the D to A converter. The output of this is frequency multiplied, amplified and passed via a Band Pass Filter to the Mains. Incoming intelligence is applied via the Filter operating in reverse, as it where, from which it is applied to a Heterodyne Mixer. This also has an input from a Local Oscillator, and the heterodyned output is applied via an analogue to digital converter to the Processor.

CLAIMS :

1.      A data transmission system for use, for instance, for transmitting data relevant to meter readings, via the electrical supply wiring, in which said data is transmitted using frequency hopping spread spectrum techniques with each data message modulated in a manner appropriate to the source of the data to be transmitted, which includes means for generating a quasi-random digital address code or codes appropriate to the source of the data to be transmitted, means to modulate each said data message to be sent on to a said quasi-random digital address code or codes appropriate to the source of the data to be transmitted, means located at a terminal at which the data messages are to be received whereby all incoming messages are offered for correlation to the address codes for data sources from which messages can be received at that terminal, and routing means whereby each message thus correlated is routed to apparatus appropriate to the source thereof, e.g. to metering equipment appropriate to the message's source where the data message relates to meter readings.

2.      A system as claimed in claim 1, which includes, for transmitting electrical metering information, means to sample the voltage and current at the customer's premises, said sampling being effected at a multiple of the mains frequency, the sampling being effected using pseudo-random phase jitter.

3.      A system as claimed in claim 2, in which for each sampling interval four samples are taken, one for voltage and three for current, the samples being successively applied to an analogue-to-digital converter to generate the appropriate bit sequences, and in which each bit of a said sequence is converted by a digital-analogue converter into the appropriate one of said frequency sequences, which frequency sequence is then modulated onto the carrier.

4.      A system as claimed in claim 2, and in which the result of each said sampling is converted into a multi-bit digital combination prior to its use for said modulation.

5.      A system as claimed in claim 2, in which each customer is allocated a block of frequencies, in which for each data bit to be sent the entire block of frequencies is sent sequentially, commencing with a defined first frequency, and in which to convey the 0 and 1 bit values the frequencies are sent in different orders, apart from the defined first frequency.

6.      A system as claimed in claim 1, and in which transmission from the said customer's premises to the sub-station is effected between the neutral wire of the mains and earth.

7.      A system as claimed in claim 6, and in which the system is earthed at the sub-station but not at the customer's premises.

8.      A system as claimed in claim 7, in which at the customer's premises the transmitting equipment with receiving equipment if provided, is directly connected to the neutral wire, and in which at the sub-station the receiving equipment, with transmitting equipment if provided, is inductively coupled to the neutral wire.

9.      A system as claimed in claim 7, in which at the customer's premises the transmitting equipment, with receiving equipment if provided is inductively coupled to a connection from the neutral wire to earth and in which at the sub-station the receiving equipment, with transmitting equipment if provided, is inductively coupled to the neutral wire.

10.      A system as claimed in claim 9, and in which each said inductively coupling is effected by a transformer one of whose windings is a single-turn loop formed by a said neutral wire, or a said neutral wire-earth connection, threaded through the core of the transformer.

11.      A data transmission system for transmitting data relevant to meter readings from customer's premises to a central station over the electrical supply wiring, in which the data is transmitted using frequency-hopping spread spectrum techniques, which includes means for generating a quasi-random digital address code or codes appropriate to the customers' premises from which the data is to be transmitted, means to modulate each said data message to be transmitted from a customer's premises to the central station on to a said quasi-random digital address code or codes appropriate to the customer's premises from which the data message is transmitted, means whereby each data message to be transmitted from the central station is modulated on to a said code or codes appropriate to the customer to whose premises the message is to be transmitted, means whereby at the central station at which the data messages from the customer's premises can be received all incoming messages are offered for correlation to the address codes for the various customer's premises from which messages can be received, means at a said customer's premises by which all incoming messages are offered for correlation to the address code or codes for that subscriber's premises, and means to route each message thus correlated to apparatus in the central station, e.g. to metering equipment appropriate to the customer's premises from which the message was received, or to a display device at a customer's premises.

12.      A system as claimed in claim 11, in which said modulation is effected by carrier frequency shifting in discrete increments in a pattern dictated by the appropriate code sequence, and in which the transmitter jumps from frequency to frequency within a predetermined set, the order of frequency usage depending on the code sequence.

13.      A system as claimed in claim 12, in which a set of $x$ frequencies is provided for each said customer's premises, each said set commencing with the same frequency, in which for each said customer's premises two sets of ($x$-1) frequencies are provided one of which follows $F_1$, one set for 0 and one for 1, and in which the two sets use the same frequencies but in different orders.

Fig.1.

0178804

## Fig.2.

SUB STATION

LINE

NEUTRAL

11

OTHER CUSTOMERS

12

RECEIVER AND TRANSMITTER

RECEIVER AND TRANSMITTER

10

## Fig.3.

SUB STATION

LINE

NEUTRAL

OTHER CUSTOMERS

RECEIVER AND TRANSMITTER

RECEIVER AND TRANSMITTER

## Fig.4.